# EUROPEAN PATENT SPECIFICATION

(11) **EP 0 426 247 B1**
(45) Date of publication and mention of the grant of the patent: **17.05.1995**
(21) Application number: 90202856.2
(22) Date of filing: 29.10.1990
(51) Int. Cl.: H05K 3/30, H05K 13/04

(54) **Method and device for placing air coils on a printed circuit board**
Verfahren und Vorrichtung zum Anordnen von Luftspulen auf einer Printplatte
Procédé et dispositif pour monter des bobines sans fer sur une platine à pistes imprimées

(30) Priority: 03.11.1989 NL 8902716
(43) Date of publication of application: 08.05.1991
(73) Proprietor: Philips Electronics N.V., 5621 BA Eindhoven (NL)
(72) Inventor: Heijnen, Alphonsus Jozephus Cornelus, NL-5656 AA Eindhoven (NL); Faes, Franciscus Cornelius Maria, NL-5656 AA Eindhoven (NL); Van Gastel, Josephus Martinus Maria, NL-5656 AA Eindhoven (NL); Van de Ven, Johannes Theodorus Antonius, NL-5656 AA Eindhoven (NL); Verberne, Petrus Adrianus Cornelis, NL-5656 AA Eindhoven (NL)
(74) Representative: Bos, Kornelis Sjoerd

(56) References cited:
- EP-A- 0 257 327
- US-A- 4 030 180
- US-A- 4 070 753
- PATENT ABSTRACTS OF JAPAN vol. 13, no. 383 (E-811) 17 November 1987,& JP-A-1 132200

## Description

The invention relates to a method of placing air coils on a printed circuit board, in which the terminals of an air coil to be placed are inserted through holes in a printed circuit board located at a given pitch distance and their inserted ends are bent over on the lower side of the printed circuit board. The invention further relates to a device for placing air coils on a printed circuit board.

Air coils are present in large numbers and in different constructions especially in T.V. tuners. Air coils will remain essential components also in the future. Air coils are of light weight, are slightly resilient and are readily deformable and hence vulnerable; for all these reasons, air coils can be processed only with difficulty. Apparatuses for mechanically mounting air coils on printed circuit boards are substantially not commercially available. Hitherto, air coils are therefore mostly mounted by hand on printed circuit boards. In the future the dimensions of T.V. tuners will become smaller, as a result of which it becomes increasingly more difficult to maintain manual mounting.

Therefore, it is necessary that methods and apparatuses are developed which permit of placing air coils mechanically on a printed circuit board. The invention therefore has for its object to provide a method, which permits of placing air coils in an efficient and reproducible manner without the air coils being deformed in an undesired manner by the placement operations and with a minimum of placement errors.

According to the invention, this object is achieved in a method comprising the following steps:
- supplying the air coils to a placement head;
- introducing the air coils into an alignment nest of the placement head, where they are subjected to preliminary stress;
- arranging the terminals of the air coils at the required pitch distance; and
- inserting the air coils simultaneously through the holes in the printed circuit board.

When the terminals of the air coils are arranged, whilst being subjected to preliminary stress, at the required pitch distance, disadvantageous effects due to variations in the pitch distance of the terminal during the operation of placing the air coils are eliminated. Due to the fact that the terminals are arranged at the required pitch distance, they can be inserted simultaneously through holes in the printed circuit board located at the same pitch distance.

In a preferred embodiment of the method according to the invention, the terminals of the air coil are pressed towards each other in a manner such that the terminals are located parallel to each other and the air coil is subjected to preliminary stress. By using an alignment nest and by pressing the terminals towards each other, the air coil is subjected to preliminary stress and is held in the alignment nest by this preliminary stress. The result of these operations is that the air coil is mounted under preliminary stress also after having been placed on the printed circuit board. After the air coil has been released from the alignment nest, this coil will tend to reassume the original shape. As a result, the terminals are clamped against the outer sides of the holes. This effect results in an additional mechanical mounting of the air coil on the printed circuit board besides the mechanical mounting obtained by the bending operation.

The invention further relates to a device for placing air coils on a printed circuit board comprising:
- a supply means for the supply of air coils;
- a placement head for receiving the air coils from the supply means and placing them in said printed circuit board, said placement head comprising a profiled alignment nest for subjecting said air coils to preliminary stress;
- a support for a printed circuit board; and
- a bending tool for bending over the inserted ends of the terminals of said air coils on the lower side of said printed circuit board.

This comparatively simple device permits of placing coils on a printed circuit board by means of the method described above. The profile of the alignment nest is adapted to the shape and the dimensions of the air coil to be placed and to the required pitch distance of the terminals. By simply placing the air coil to be placed in the alignment nest, the coil is stressed and the terminals are arranged at the desired pitch distance, after which the coil can be placed from the alignment nest on the printed circuit board in that the terminals are inserted through the relevant holes in the printed circuit board and ultimately the inserted ends of the terminals are bent over on the lower side of the printed circuit board.

It should be noted that it is known from US-PS 3,465,408 to place U-shaped wire parts, more particularly bridge parts, on a substrate. A piece of the wire is then introduced into a forming nest, is held by a vacuum, is formed into a U-shaped bridge part and is placed on a substrate. As already stated, the bridge parts are held by a vacuum and not as a result of pre-stresses.

A preferred embodiment of the device according to the invention is characterized in that the placement head is displaceable between a rest position, a pick-up position and a mounting position. In the pick-up position near the supply means, the air coils to be placed are presented, are introduced into the alignment nest and are moved by displacement of the placement head from the pick-up position to the mounting position above a printed circuit board and placed on the printed circuit board. The displacements of the placement head can take place in the same plane.

The air coils to be placed can be supplied in any suitable manner, for example by means of a vibrating filler. However, the air coils are preferably supplied in rod magazines. For processing the air coils supplied in rod magazines, the supply means comprise in another preferred embodiment of the device according to the invention a magazine support and a separation block with a separation member and a lifting member. Due to these constructive measures, it is possible to introduce air coils supplied in rod magazines one by one without disturbance from the rod magazine into the alignment nest. This device is particularly suitable for processing air coils supplied in magazines, as described in a co-pending Application of the Applicant.

A further preferred embodiment of the device according to the invention is characterized by a pre-alignment block comprising a pre-alignment shaft. Before the coils to be placed are introduced into the alignment nest, they are guided through the pre-alignment shaft and are thus pre-aligned. As a result, tolerances in the positions of the air coils in the supply means and in the pick-up position of the placement head are eliminated.

In a still further preferred embodiment of the device according to the invention, the placement head comprises a pressure member having a saddle-shaped end and a pick-up member surrounding the pressure member, the pick-up member and the pressure member being displaceable with respect to each other and the pick-up member and the saddle-shaped end of the pressure member constituting the edges of the alignment nest. The air coil introduced into the alignment nest constituted by the pressure member and the pick-up member bears with its turns on the saddle-shaped end of the pressure member, while the terminals of the air coil are compressed by the walls of the pick-up member. In this position of the air coil, the placement head is moved to a position just above the printed circuit board; due to a relative displacement of the pressure member and the pick-up member, the terminals are inserted through the relevant holes in the printed circuit board. When bending the inserted ends of the terminals, the support of the air coil by the placement head is maintained at least by the pressure member.

A compact, robust and comparatively simple construction of the placement head is obtained in a further preferred embodiment of the device according to the invention in that the pressure member is fixedly connected to a cylinder block in that the pick-up member forms part of a cylindrical housing, which surrounds the cylinder block and is coupled to a piston in the cylinder block.

Another preferred embodiment of the device according to the invention is characterized in that the supply means, the separation block, the pre-alignment block, the placement head and the bending tool are joined on a common frame to form a placement module. The said parts of the device are designed for specific products and should be adapted to every type of coil. Several of such placement modules for placing different types of coils can be joined on a common frame to form a modular system.

In connection with the measures described above, it should be noted that devices for placing components supplied in rod magazines, which devices are provided with separation members, are known per se, for example, from US-PS 4,733,459 and GB PS 1,264,294. These known devices are not concerned, however, with the placement of air coils, while they do not comprise either means for processing such vulnerable components.

The invention will now be described more fully with reference to embodiments shown in the drawing. In the drawing:
Figure 1 is a front elevation of an air coil;
Figure 2 is a side elevation of the air coil shown in Figure 1;
Figure 3 shows an embodiment of the device according to the invention;
Figure 4 shows an embodiment of the separation block and of the pre-alignment block;
Figure 5 is a bottom view taken on → V in Figure 4 of a part of the pre-alignment block;
Figures 6 to 9 show the separation block, the pre-alignment block and the placement head at successive stages;
Figure 10 shows the device illustrated in Figure 3 during the operation of placing an air coil on a printed circuit board;
Figure 11 is a longitudinal sectional view of the placement head;
Figure 12 is a longitudinal sectional view of the placement head taken on the line XII-XII in Figure 11;
Figure 13 shows on an enlarged scale a cross-section of the alignment nest taken on the line XIII-XIII in Figure 11;
Figure 14 shows the device according to the invention in another embodiment.

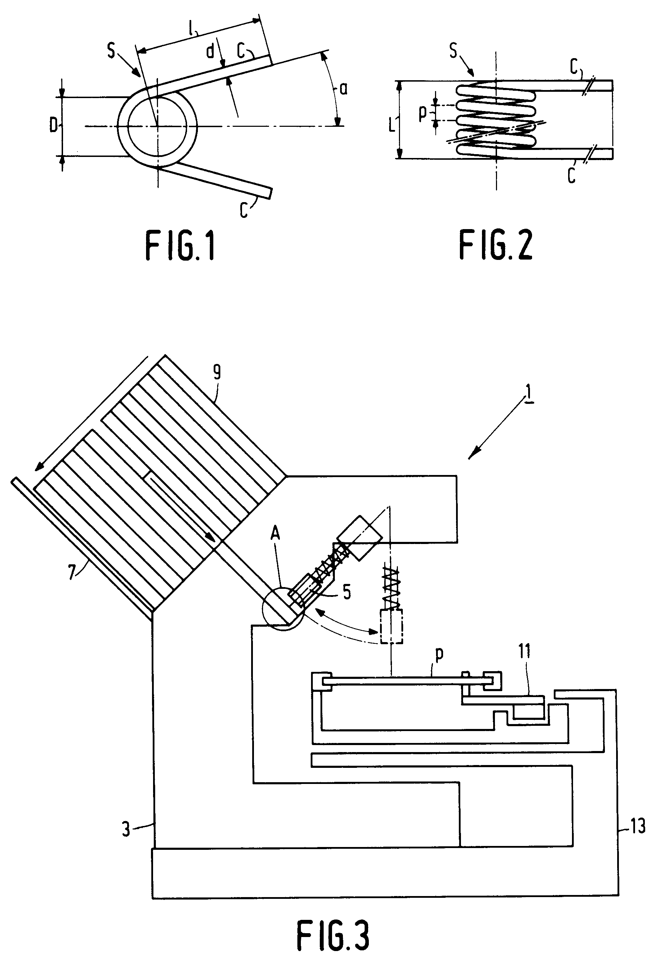

Figures 1 and 2 show an embodiment of an air coil S having a length L, a coil diameter D corresponding to the inner diameter of the air coil; a wire diameter d and a pitch distance P between the turns; the two terminals C of the air coil have a length l and enclose an angle 2a with each other. Such air coils are used in different constructions, especially in T.V. tuners. The most frequently used air coils have a winding or coil diameter which can vary from 1.7 to 3.7 mm, a length between 1.5 and 11.5 mm and a wire diameter of 0.4 to 0.5 mm; the number of turns can vary between 1.5 and 20.5. The said numbers are given only by way of example. Theoretically, there are no limitations in the measures of the coils. Air coils are generally made of copper wire. Such air coils are readily deformable, have resilient properties and are very vulnerable. It must be ensured that such air coils are not deformed by placement operations, i.e. by operations carried out after the coils have been wound. A damage and an undesired deformation of the air coils can be prevented by the use of the method according to the invention and by the use of the device according to the invention.

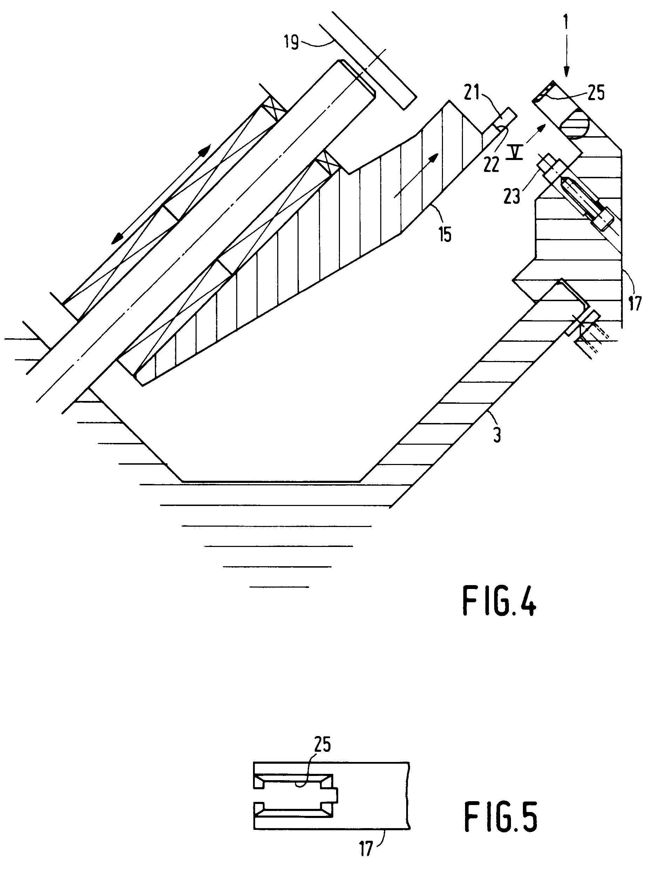

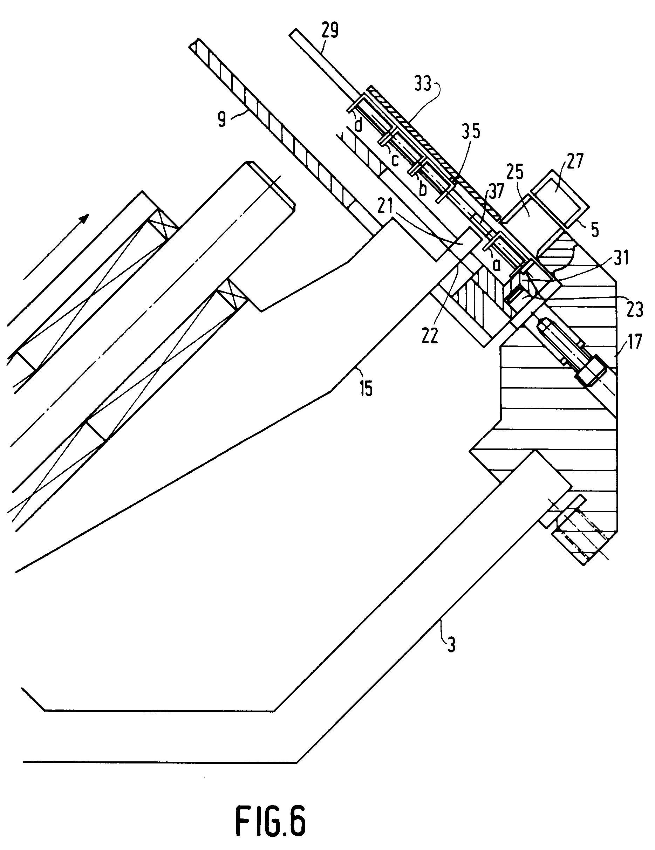

The device 1 shown diagrammatically in Figure 3 mainly comprises a frame 3 having a placement head 5, a holder 7 for rod magazines 9, a means 11 for supplying, positioning and discharging printed circuit boards P and a common framework 13. The placement head 5 is displaceable between a rest position, a pick-up position and a mounting position. In Figure 3, the placement head is indicated by broken lines in the rest position and by full lines in the pick-up position. The air coils to be placed are supplied by means of the rod magazines 9, which are moved one by one into a supply position. In the supply position, the magazine 9 is located with one end under the placement head 5 located in the pick-up position. The region encircled and indicated by A in Figure 3 is shown on an enlarged scale in Figures 4 to 9. Figure 4 shows a part of the frame 3 and a separation block 15, a pre-alignment block 17 and a support 19 for a rod magazine. The separation block 15, which can be moved up and down, comprises a separation member 21, which takes the form of a thin sheet, and lifting members 22 taking the form of horizontal shoulders on either side of the separation member 21. To the pre-alignment block 17 fixedly provided on the frame 3 is secured a centering pin 23 for positioning a rod magazine to be placed. Reference numeral 25 designates a pre-alignment shaft, which tapers on the lower side. Figure 5 shows the pre-alignment shaft 25, viewed from the lower side in the direction of → V in Figure 4.

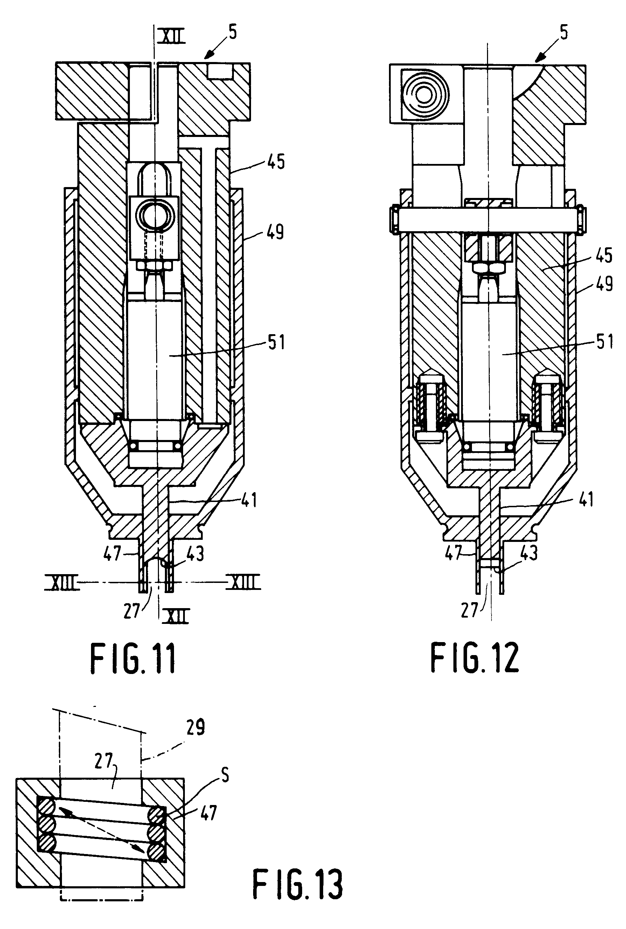

Figures 6 to 9 show the relative positions of the placement head 5, the separation block 15 and the pre-alignment block 17. The placement head 5 comprising an alignment nest 27 is shown only diagrammatically and will be described more fully hereinafter with reference to Figures 11 to 13. Figure 6 shows a rod magazine 9 in the supply position, which is positioned by the centering pin 23. The rod magazine mainly comprises a needle 29, onto which the air coils a, b, c, d are threaded. The needle 29 bears with the free end on a supporting block 31. Reference numeral 33 denotes a roof portion, which can be subdivided and on which a braking block 35 is secured. Further details of this rod magazine are described in a co-pending Application of the Applicant. Due to the oblique arrangement of the rod magazine 9, the air coils tend to move in the direction of the supporting block 31 under the influence of the force of gravity on the needle 29.

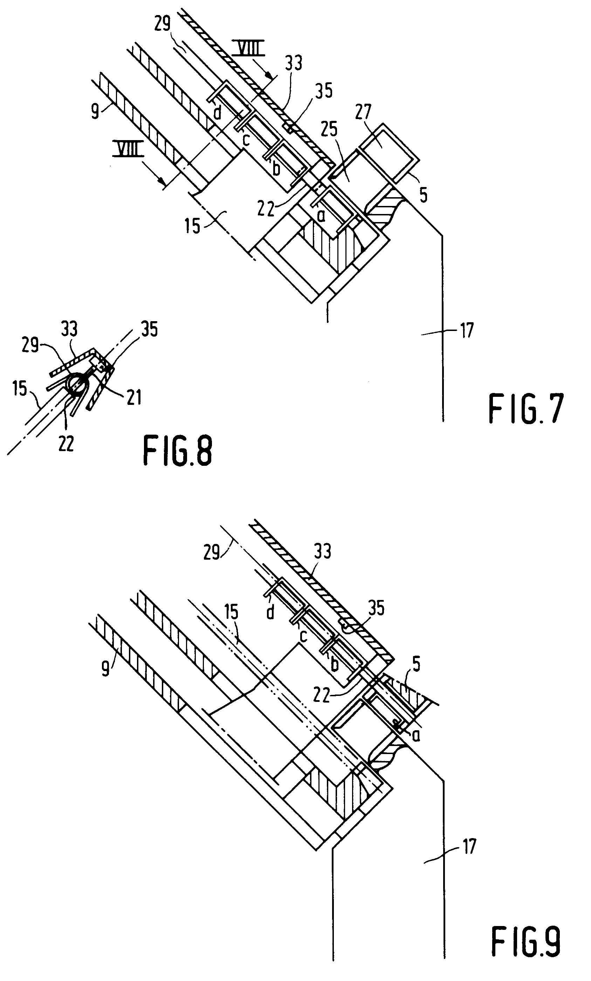

In the situation shown in Figure 6, the air coil a is located in the delivery position, in which it engages the supporting block 31 and is situated under the pre-alignment shaft 25. The placement head 5 with the alignment nest 27 is located above the pre-alignment shaft 25. The air coil b is stopped by the braking block 35, which bears on the air coil b. The free end of the separation member 21 is located under the needle 29, i.e. at the area of a gap 37 in the needle. The introduction of the air coil a into the alignment nest 27 of the placement head 5 will be described with reference to Figures 7 to 9.

In the situation shown in Figure 7, the needle 29 bears with its free end still on the supporting block 31; the separation block 15 has moved upwards so that the separation member 21 is displaced through the gap 37 and contacts with its free end the roof portion 33, which is lifted together with the braking block 35; the air coil b is thus released so that all coils can shift by one position and the coil b is withheld by the separation member 21. The lifting members 22 are just in touch with the needle 29. Figure 8 shows a cross-section taken on the line VIII-VIII with the separation member 21 reaching through the gap 37 and the lifting members 22 just in touch with the needle 29. It can further be clearly seen that the roof portion 33 with the braking block 35 is moved upwards.

Due to a further upward movement of the separation block 15, the needle 29 is now also moved upwards by the lifting members 22, is passed together with the coil a through the pre-alignment shaft 25 and is ultimately pressed into the alignment nest 27 of the placement head 5. During the passage through the pre-alignment shaft 25, the coil a on the needle 29 is precentered with respect to the alignment nest 27. During the introduction of the coil a into the alignment nest 27, the coil terminals are resiliently compressed so that the air coil a is pre-stressed in the alignment nest 27. During this further upward movement of the separation block 15, the roof portion 33 with the braking block 35 is also moved upwards. By a displacement of the placement head 5 in the longitudinal direction of the needle 29 and away from the needle, the air coil a is pulled off the needle and can then be placed on a printed circuit board. During the downward movement of the separation block 15 now occurring, first the free end of the needle 29 again bears on the supporting block 31. By a further downward movement of the separation block 15, the roof portion 33 with the braking block 35 moves further downwards until the braking block 35 bears on the air coil c, as a result of which the air coil c is withheld together with all the following air coils. After the separation member 21 has ultimately been pulled out of the gap 37 in the needle 29, the coil b can shift to the delivery position, in which it engages the supporting block 31. The coil b thus separated is now ready to be introduced into the alignment nest 27 in the manner described above after the placement head 5 has returned to the position shown in Figure 6.

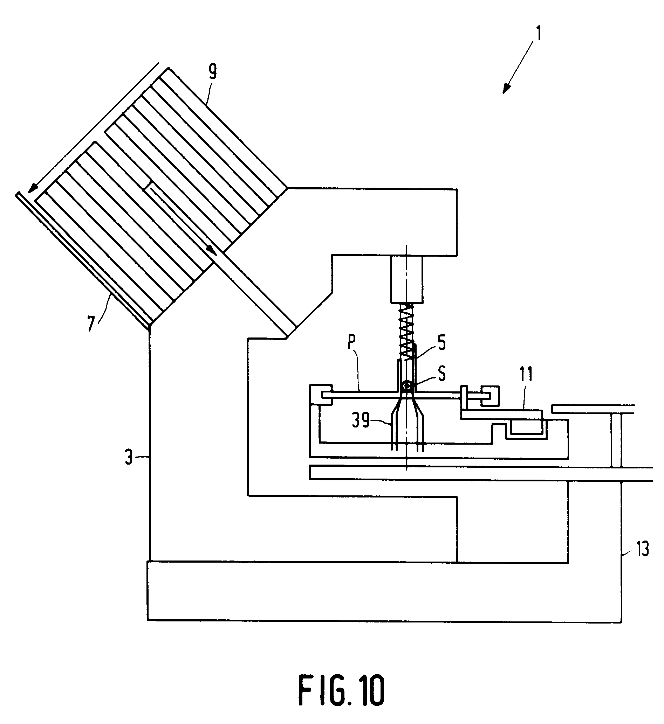

Figure 10 shows the device of Figure 3 with the placement head 5 in a mounting position above a printed circuit board P. After the terminals of the air coil accommodated in the alignment nest have been inserted through corresponding holes in the printed circuit board, the ends are bent over on the lower side of the printed circuit board P by means of a bending tool 39.

Figures 11 and 12 show the placement head 5 in a longitudinal sectional view. The placement head 5 comprises a pressure member 41, which is provided with a saddle-shaped end 43 and is fixedly connected to a cylinder block 45. The pressure member 41 is surrounded by a pick-up member 47, which forms part of a cylindrical housing 49, which surrounds the cylinder block 45 and is coupled to a piston 51 in the cylinder block 45. The saddle-shaped end 43 of the pressure member 41 and the pick-up member 47 of the housing 49 constitute the walls of the alignment nest 27. By the supply of a pressure medium, the piston 51 in the cylinder block 45 can be displaced with a view to a relative displacement of the cylinder block 45 and the housing 49 and of the pressure member 41 and the pick-up member 47, respectively.

Figure 13 shows on an enlarged scale a cross-section of the alignment nest taken on the line XIII-XIII in Figure 11. It can be clearly seen therefrom that the walls of the pick-up member 47, which is bifurcate, are adapted to the position of the turns of the air coil to be placed. The form of the saddle-shaped end 43 of the pressure member 41 is adapted to the outer diameter of the turns of the air coil.

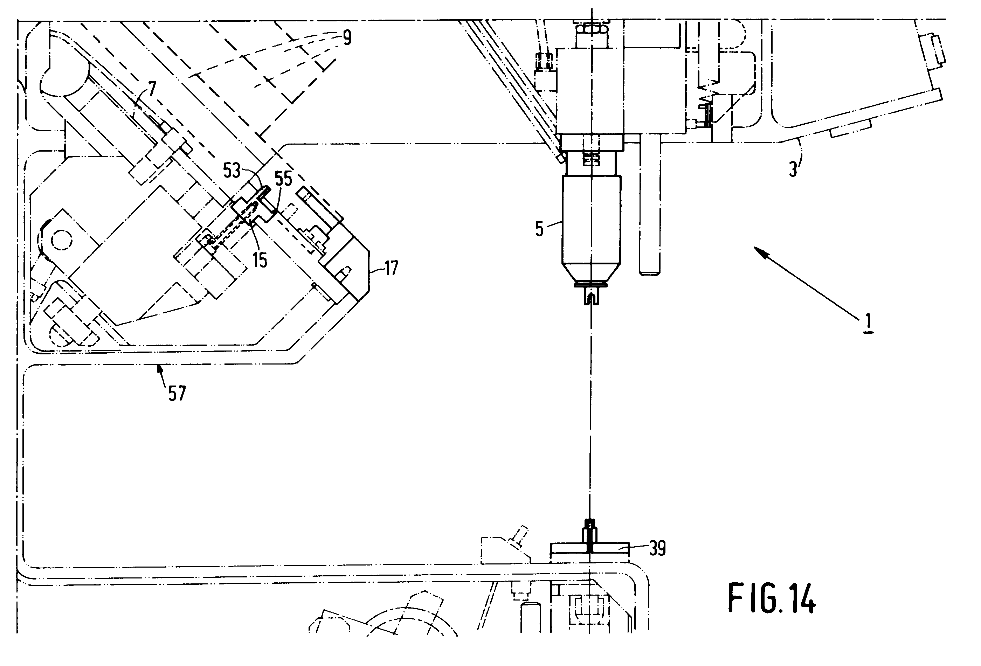

Figure 14 shows another embodiment of the device according to the invention and also comprises a frame 3 with a placement head 5, a holder 7 for rod magazines 9, a separation block 15, a pre-alignment block 17 and a bending tool 39. The placement head, the pre-alignment block and the bending tool are identical to the embodiment already described. As far as the separation block 15 is concerned, in the embodiment already described, the separation member 21 and the lifting member 22 are joined to form a common member. In the embodiment shown in Figure 14, the separation block 15 comprises a bifurcate separation member 53 and a separate lifting member 55, which members fulfil the same functions as the separation member 21 and the lifting member 22, respectively. When the separation block 15 moves upwards, the needle 29 of the rod magazine 9 is located between the limbs of the bifurcate separation member, which causes the roof portion 33 and the braking block 35 to be lifted. The lifting member 55 ensures that the needle 29 is displaced.

The device according to the invention comprises a number of parts designed for specific products, i.e. parts which must be adapted to a given type of air coil. These parts are especially the placement head 5, the separation block 15, the pre-alignment block 17 and the bending tool 39. Preferably, these parts are joined on a common frame to form a placement module 57. Further parts are equal for all placement modules. For placing coils having different shapes and dimensions, several of such modules, one for each type of coil, can be placed on a common framework, which also comprises the means for supplying, positioning and discharging the printed circuit boards. The modules are arranged in x-y coordinates and are then positioned. Due to this measure, a simple drive of the placement head is sufficient. Due to the fact that in the practical embodiment the modules have only a very small width of about 125 mm, an extremely compact construction of the whole device is obtained. The modules can be exchanged in a comparatively short time.

## Claims

1. A method of placing air coils (S) on a printed circuit board (P), in which the terminals (C) of an air coil to be placed are inserted through holes in a printed circuit board located at a given pitch distance and their inserted ends are bent over on the lower side of the printed circuit board, comprising the following steps:
- supplying the air coils (S) to a placement head (5);
- introducing the air coils (S) into an alignment nest (27) of the placement head (5), where they are subjected to preliminary stress;
- arranging the terminals (C) of the air coils (S) at the required pitch distance; and
- inserting the air coils (S) simultaneously through the holes in the printed circuit board (P).

2. A method as claimed in Claim 1, characterized in that the terminals (C) of the air coil (S) are pressed towards each other, in a manner such that the terminals are located parallel to each other and the air coil is subjected to preliminary stress.

3. A device for placing air coils (S) on a printed circuit board (P) comprising:
- a supply means (7,9,15-25,29-37) for the supply of air coils (S);
- a placement head (5) for receiving the air coils (S) from the supply means and placing them in said printed circuit board (P), said placement head (5) comprising a profiled alignment nest (27) for subjecting said air coils to preliminary stress;
- a support for a printed circuit board (P); and
- a bending tool (39) for bending over the inserted ends of the terminals (C) of said air coils (S) on the lower side of said printed circuit board (S).

4. A device as claimed in Claim 3, characterized in that the placement head (5) is displaceable between a rest position, a pick-up position and a mounting position.

5. A device as claimed in Claim 3 or 4, characterized in that the supply means comprises a magazine support (19) and a separation block (15) with a separation member (21) and a lifting member (22).

6. A device as claimed in Claim 3, 4 or 5, characterized by a pre-alignment block (17), which comprises a pre-alignment shaft (25).

7. A device as claimed in Claim 3, 4, 5 or 6, characterized in that the placement head (5) comprises a pressure member (41) having a saddle-shaped end (43) and a pick-up member (47) surrounding the pressure member (41), the pick-up member and the pressure member being displaceable with respect to each other and the pick-up member and the saddle-shaped end of the pressure member constituting the edges of the alignment nest (27).

8. A device as claimed in Claim 7, characterized in that the pressure member (41) is fixedly connected to a cylinder block (45), and in that the pick-up member (47) forms part of a cylindrical housing (49), said housing surrounding the cylinder block (45), and being coupled to a piston (51) in the cylinder block (45).

9. A device as claimed in any one of Claims 3 to 8, characterized in that the supply means (9), the separation block (15), the pre-alignment block (17), the placement head (5) and the bending tool (39) are joined on a common frame (13) to form a placement module.

## Patentansprüche

1. Verfahren zur Bestückung einer Printplatte (P) mit Luftspulen (S), in dem die Anschlüsse (C) einer anzubringenden Luftspule durch in einem bestimmten gegenseitigen Abstand angeordnete Löcher in eine Printplatte eingesteckt und ihre durchgesteckten Enden um die Unterseite der Printplatte gebogen werden, wobei das Verfahren folgende Stufen umfaßt:
- Beschickung des Bestückungskopfes (5) mit Luftspulen (S),
- Einschub der Luftspulen (S) in eine Ausrichtkammer (27) des Bestückungskopfes (5), in der sie unter Vorspannung gesetzt werden,
- Anordnung der Anschlußenden (C) der Luftspulen (S) im erforderlichen gegenseitigen Abstand und
- gleichzeitiges Einsetzen der Luftspulen (S) durch die Löcher in der Printplatte (P).

2. Verfahren nach Anspruch 1, dadurch gekennzeichnet, daß die Anschlußenden (C) der Luftspulen (S) so aufeinander zu gedrückt werden, daß die Anschlüsse parallel zueinander angeordnet sind und die Luftspule unter Vorspannung gesetzt wird.

3. Vorrichtung zur Bestückung einer Printplatte (P) mit Luftspulen (S) mit:
- Beschickungsmitteln (7, 9, 15 - 25, 29 - 37) zur Zufuhr von Luftspulen (S),
- einem Bestückungskopf (5) zur Beschickung mit Luftspulen (S) aus den Beschickungsmitteln und zur Bestückung vorgenannter Printplatte (P) mit diesen Spulen, wobei dieser Bestückungskopf (5) mit einer profilierten Ausrichtkammer (27) versehen ist, um diese Luftspulen unter Vorspannung zu setzen,
- einen Träger für eine Printplatte (P) und
- einem Biegewerkzeug (39) zum Umbiegen der durchgesteckten Anschlußenden (C) dieser Luftspulen (S) an der Unterseite dieser Printplatten (P).

4. Vorrichtung nach Anspruch 3, dadurch gekennzeichnet, daß der Bestückungskopf (5) zwischen einer Ruhelage, einer Beschickungslage und einer Bestückungslage beweglich ist.

5. Vorrichtung nach Ansprüchen 3 oder 4, dadurch gekennzeichnet, daß die Beschickungsmittel einen Magazinträger (19) und einen Trennblock (15) mit einem Trennglied (21) und einem Hebeglied (22) enthalten.

6. Vorrichtung nach Ansprüchen 3, 4 oder 5, durch einen Vorausrichtblock (17) gekennzeichnet, der einen Vorausrichtschacht (25) enthält.

7. Vorrichtung nach Ansprüchen 3, 4, 5 oder 6 dadurch gekennzeichnet, daß der Bestückungskopf (5) einen Druckstempel (41) mit einem sattelförmigen Ende (43) und ein den Druckstempel (41) umgebendes Aufgreifglied (47) enthält, wobei das Aufgreifglied und der Druckstempel zueinander verschiebbar sind und das Aufgreifglied und das sattelförmige Ende des Druckstempels die Kanten der Ausrichtkammer (27) bilden.

8. Vorrichtung nach Anspruch 7, dadurch gekennzeichnet, daß der Druckstempel (41) fest mit einem Zylinderblock (45) verbunden ist und das Aufgreifglied (47) einen Bestandteil eines zylindrischen Gehäuse (49) bildet, das den Zylinderblock (45) umgibt und mit einem Kolben (51) im Zylinderblock (45) gekoppelt ist.

9. Vorrichtung nach einem der Ansprüche 3 bis 8, dadurch gekennzeichnet, daß die Beschickungsmittel (9), der Trennblock (15), der Vorausrichtblock (17), der Bestückungskopf (5) und das Biegewerkzeug (39) auf einem gemeinsamen Rahmen (13) zu einem Bestückungsmodul zusammengefaßt sind.

## Revendications

1. Procédé pour la mise en place de bobines sans fer (S) sur un panneau à circuits imprimés (P), selon lequel les bornes (C) d'une bobine sans fer à placer sont insérés à travers des trous dans un panneau à circuits imprimés situés à une distance de pas donnée et leurs extrémités insérées sont fléchies du côté inférieur du panneau à circuits imprimés, comprenant les étapes suivantes:
- l'amenée des bobines sans fer (S) à une tête de mise en place (5);
- l'introduction des bobines sans fer (S) dans un nid d'alignement (27) de la tête de mise en place (5) où elles sont soumises à une tension préalable;
- la disposition des bornes (C) des bobines sans fer (S) à la distance de pas requise et
- l'insertion des bobines sans fer (S) simultanément à travers les trous dans le panneau à circuits imprimés (P).

2. Procédé selon la revendication 1, caractérisé en ce que les bornes (C) de la bobine sans fer (S) sont pressées l'une vers l'autre de façon que les bornes se situent parallèlement l'une par rapport à l'autre et que la bobine sans fer soit soumise à une tension préalable.

3. Dispositif pour la mise en place de bobines sans fer (S) sur un panneau à circuits imprimés (P) comprenant:
- un moyen d'amenée (7, 9. 15-25, 29-37) pour l'amenée des bobines sans fer (S);
- une tête de mise en place (5) pour la réception des bobines sans fer (S) à partir des moyens d'amenée et la mise en place dans ledit panneau à circuits imprimés (P), ladite tête de mise en place (5) comprenant un nid d'alignement profilé (27) pour soumettre les dites bobines sans fer à une tension préalable;
- un support pour un panneau à circuits imprimés (P);
- un outil de flexion (39) pour fléchir les extrémités insérées des bornes (C) desdites bobines sans fer (S) du côté inférieur dudit panneau à circuits imprimés (S).

4. Dispositif selon la revendication 3, caractérisé en ce que la tête de mise en place (5) est déplaçable entre une position de repos, une position de prélèvement et une position de montage.

5. Dispositif selon les revendications 3 ou 4, caractérisé en ce que le moyen d'amenée comporte un support de magasin (19) et un bloc de séparation (15) muni d'un élément de séparation (21) et d'un élément de soulèvement (22).

6. Dispositif selon les revendications 3, 4, ou 5, caractérisé par un bloc de pré-alignement (17), qui est muni d'un tuyau de pré-alignement (25).

7. Dispositif selon les revendications 3, 4, 5, ou 6, caractérisé en ce que la tête de mise en place (5) comporte un élément de pression (41) présentant une extrémité en forme de selle (43) et un élément de prélèvement (47) entourant l'élément de pression (41), l'élément de prélèvement et l'élément de pression étant déplaçables l'un par rapport à l'autre et l'élément de prélèvement et l'extrémité en forme de selle de l'élément de pression constituant les bords du nid d'alignement (27).

8. Dispositif selon la revendication 7, caractérisé en ce que l'élément de pression (41) est rigidement relié à un bloc cylindrique (45) et en ce que l'élément de prélèvement (47) fait partie d'un boîtier cylindrique (49), ledit boîtier entourant le bloc cylindrique (45) et étant accouplé à un piston (51) dans le bloc cylindrique (45).

9. Dispositif selon l'une des revendications 3 à 8, caractérisé en ce que le moyen d'amenée (9), le bloc de séparation (15), le bloc de pré-alignement (17), la tête de mise en place (5) et l'outil de flexion (39) sont réunis sur un châssis commun (13) pour former un module de mise en place.
